# EUROPEAN PATENT APPLICATION

(11) **EP 2 287 910 A1**
(43) Date of publication of application: **23.02.2011**
(21) Application number: 10172302.1
(22) Date of filing: 09.08.2010
(51) Int. Cl.: H01L 27/146

(54) **Improvements in or relating to filters in an image sensor**

(30) Priority: 17.08.2009 GB 0914350
(71) Applicant: STMicroelectronics (Research & Development) Limited, Marlow, Buckinghamshire SL7 1YL (GB)
(72) Inventor: Findlay, Ewan Donald, Dollar Clackmannanshire, FK14 7ES (GB); Nicol, Robert Leiper, Lanarkshire, ML11 0PR (GB)
(74) Representative: Anderson, Angela Mary

(57) **Abstract**

A method of forming an image sensor of the type having a sensor, a cover and a filter, the method comprising the steps of: applying a filter layer (304) to a cover layer (300) by masking the cover layer (300) with a predetermined pattern and applying the filter layer (304) by a deposition process; bonding the cover layer (300) to a sensor layer (302) including a plurality of sensors wherein the predetermined pattern gives rise to a filter layer (304) which is aligned with each sensor and wherein there are gaps in the filter layer (304) around each sensor.

## Description

### Field of the invention

The present invention concerns improvements in or relating to filters in an image sensor, such as chip scale package image sensor.

### Background of the invention

Chip scale package (CSP) image sensors are commonly used in mobile phone cameras and many other devices. These types of image sensors are relatively expensive to manufacture, however in the long-term increased yield can mitigate some of the expenses. A CPS for a typical image sensor comprises: a silicon chip on which the an image sensor is constructed; a cover, such as glass, which prevents particular ingress and contamination of the sensor surface during the construction process; some form of bonding to bond the cover to the silicon; and electrical connections between the active surface (i.e. the surface on which the sensor is built) and the rear thereby allowing signals to pass to external electronics where appropriate.

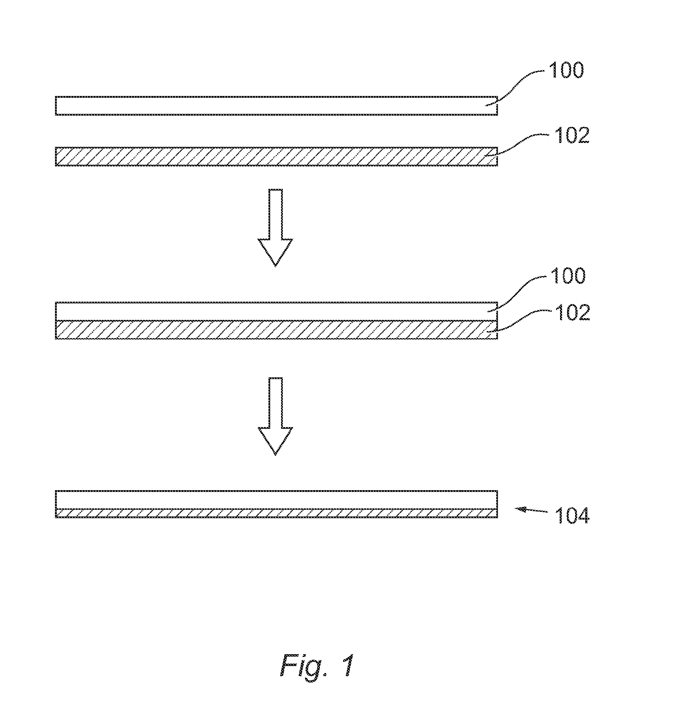

A CPS is typically manufactured using a wafer related process to bond a wafer of silicon to the cover. This combination of wafer and cover is then processed to provide the required connectivity before the wafer is cut into chip scale packages. This often requires a process for "thinning" the silicon wafer to obtain the required back to front connectivity. This can be seen in figure 1 where the cover 100 is bonded to a silicon wafer 102 in a wafer level packaging-through silicon via (WLP-TSV) process. The silicon wafer generally undergoes back grinding to allow the TSV process to be completed. The thinning of the silicon can be seen in the final combination 104 which is ready for the WLP-TSV processing.

In order for the silicon and glass cover to be processed together it is necessary to match the thermal expansion of the two parts to prevent the combined glass silicon wafer warping and eventually fracturing.

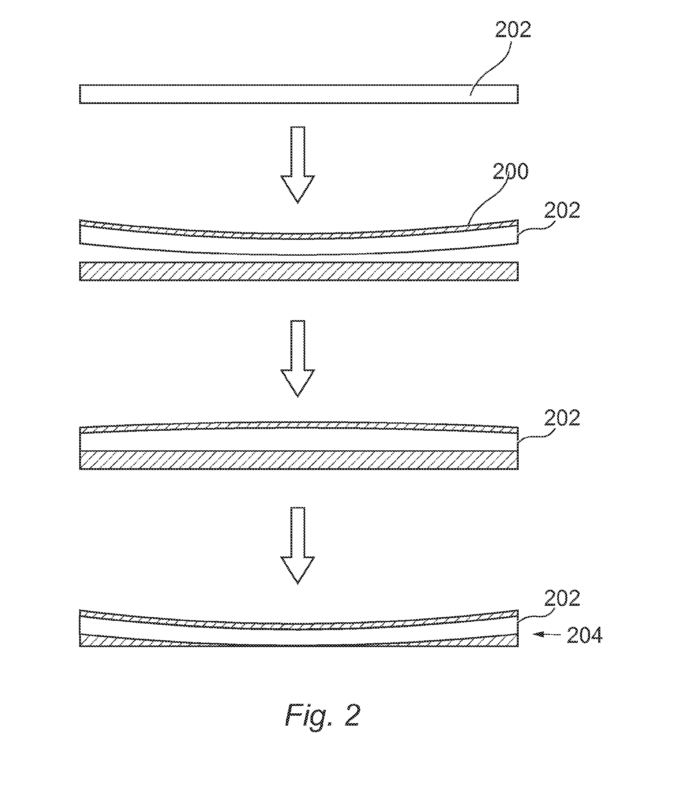

There are clearly a number of advantages and disadvantages associated with current CSP image sensor packaging. Some of these disadvantages become accentuated when the CSP concept requires an IR to UV filter, which may be made by vacuum deposition of dielectric layers on a separate piece of glass. Referring to figure 2, the deposition of a filter coating 200 onto the glass wafer 202 gives rise to a compression stress that causes the glass wafer to bow or warp. Subsequent processing of and the silicon/glass laminate 204 can give rise to thickness variations on the silicon which are incompatible with TSV processing. The high stress in the laminate during the grinding process gives rise to thinning of the wafer in the centre thereof. This problem can be identified in a number of different scenarios where a filter is coated onto a glass element, such as an objective lens or micro lenses. Any curvature caused by depositing the filter layer can lead to spectral inconsistencies over the filter or element. This makes it hard to monitor the spectral response of the filters in certain situations.

Attempts to overcome the problems have relied on the use of glass that is expansion matched to the silicon and carried out as follows. The silicon and an uncoated glass wafer are prepared by bonding, revealing contacts etc. The wafer is then cut to produce single CSPs that are cleaned and placed in a coating jig. The packages are then coated with a filter on the upper surface of the glass to complete the finished CSP. A significant disadvantage of this process is the production of particles during the cutting and handling of the CSP prior to application of the filter coating which introduces contamination to the final CSP. This in turn produces significant yield loss on a potentially expensive component during a low-cost part of the procedure.

Another attempt has been to coat the glass on both sides to try and keep the glass form flat. The process then proceeds to bond the silicon and coated glass wafer together and cut them into the individual modules. This process must be highly accurate to ensure that any defect size is less than a pixel diagonal of the sensor on the lower surface. In addition there is potential for variations in the amount of coating which can continue to generate warping of the glass wafer and therefore uneven thinning of the silicon wafer.

### Object of the invention

One object of the present invention is to overcome at least some of the problems associated with the prior art.

A further object of the present invention is to make a CSP comprising a filter using deposition of dielectric layers as part of the CSP whilst in wafer form.

### Summary of the invention

The present invention provides a device as set out in the accompanying claims.

According to one embodiment of the present invention, there is provided a method of forming an image sensor of the type having a sensor, a cover and a filter, the method comprising the steps of: applying a filter layer to a cover layer by masking the cover layer with a predetermined pattern and applying the filter layer by a deposition process; and bonding the cover layer to a sensor layer including a plurality of sensors, wherein the predetermined pattern gives rise to a filter layer which is aligned with each sensor and wherein there are gaps in the filter layer around each sensor.

The present invention provides a number of advantages, in particular the problems of differential thermal expansion between a coating and the wafer scale package are significantly reduced thereby reducing yield loss. As stress considerations are less of an issue the filter can be designed with other criteria dominating the choices, for example achieving appropriate colour accuracy for a camera in the final application. As stress is less of an issue the glass layer does not need to be as thick which can improve the space available for other camera elements. This results in an improved camera tracked length. In some situations to different glass layers are used one for the cover and one to support the filter. The present invention provides a means by which only one layer of glass is necessary.

The present invention also has a number of advantages in terms of handling the CPS and minimising contamination. As the filter layer is not impacted by the cutting places there is less debris and contamination. In addition as the filter is applied by a deposition process a clean room environment is maintained at all times and less contamination is likely.

The present invention guarantees a higher yield without additional costs or processing.

### Brief description of the drawings

Reference will now be made, by way of example, to the accompanying drawings, in which:
Figure 1 is a flow diagram of a normal WLP-TSV process flow, in accordance with the prior art;
Figure 2 is a flow diagram of the WLP-TSV process including an IR filter, in accordance with the prior art;
Figure 3 is a flow chart of a WLP-TSV process including the addition of a filter, in accordance with an embodiment of the invention;
Figure 4 is a flow chart of a WLP-TSV process showing certain benefits of the present invention;
Figure 5 is a top view of a glass wafer bonded to a silicon wafer, in accordance with an embodiment of the invention.

### Detailed description of the preferred embodiments

The present invention proposes a method and chip that reduces the effect of differential thermal expansion of the silicon and glass layers. This reduces the production loss due to cutting the combined layer into individual chips and enables the use of a viable coating process.

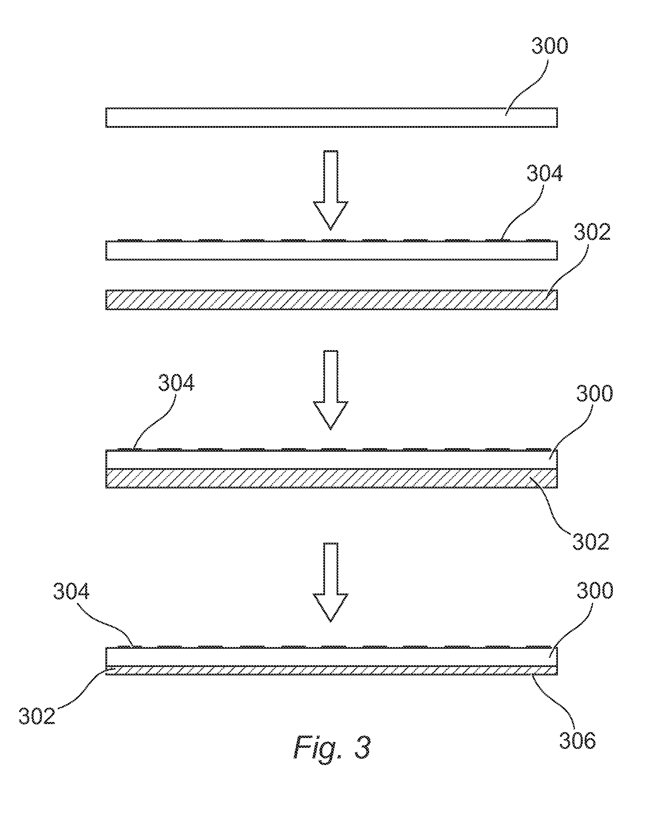

Referring to figure 3, a glass wafer 300 and silicon wafer 302 are shown. A filter layer 304 is applied to the glass wafer by means of a vapour deposition coating process using shadow masking. The shadow masking means that the coating that forms the filter is not continuous and an element of the coating is applied to align with each individual CPS. This means that compression stresses caused by the coating are localised to the local die area for the filter in question. As a result, there is no compression stress on the whole glass wafer and a low warp configuration is retained.

The glass wafer can then be bonded with the silicon wafer and any subsequent backgrind process will result in significantly less thickness variations that would be detrimental to the TSV process. The final silicon glass combination or laminate is shown as 306.

The shadow mask (not shown) can be a contact mask or near contact mask having a minimum height to allow the first filter characteristics to remain within the requirements for a clear aperture at the upper surface of the CSP for the final resulting camera. The mask is in the form of a grid that coincides with the "step repeat" of the sensors on the silicon wafer. This ensures that each filter is correctly positioned relative to the final individual CSPs.

As described the filter is applied before bonding the silicon and glass layers. However, the filter could be applied after the two layers have been bonded together.

The filter is formed by an appropriate material depending on the frequency requirements for transmission and suppression of radiation. For a UV-IR filter a typical material may include multiple thin film layers of silicon oxide with silicon nitride. Similarly different materials for the glass wafer and silicon wafer may be appropriate in different circumstances. For example, borosilicate or alumino-silicate float drawn glasses.

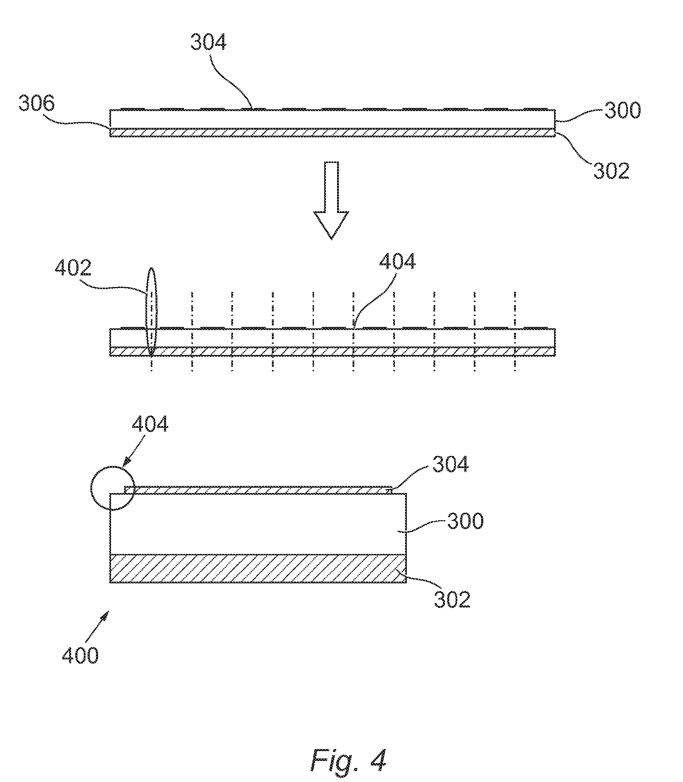

Figure 4 shows the next stages of the process where the combined silicon glass laminate with filters can be cut into individual CSP modules 400.

The cuts are made with a wafer saw 402 in alignment with the gaps between the filter coating which have been applied by means of the mask. Due to the size of the gaps between the filter coating, the filter material never comes in contact with the saw blade and thus avoids chipping or delamination of the filter coating as seen at 404.

As a consequence of the grid like filter layer, there are less stresses between the filter coating and the glass wafer thus avoiding bowing and warping of the overall package which could ultimately result in stress failure of the module. As a first approximation, the linear stress in the module according to the present invention is reduced by a ratio of the dimension of the coated area to that of the step repeat distance in that direction.

A significant advantage of the present invention is that due to the fact that as stress is reduced the ability to tune the filter to give required optical and reliability properties can come before the requirement to minimise stress. This provides more flexibility in the design process and enables a better optical standard to be achieved.

An advantage over implementing the filter in a two sided coating is that near field defect criteria, where defects are compared to pixel size, are substantially removed. Instead with the present invention the size of the allowable defects is now dictated by the exit pupil of the objective lens and not the effects of the coating.

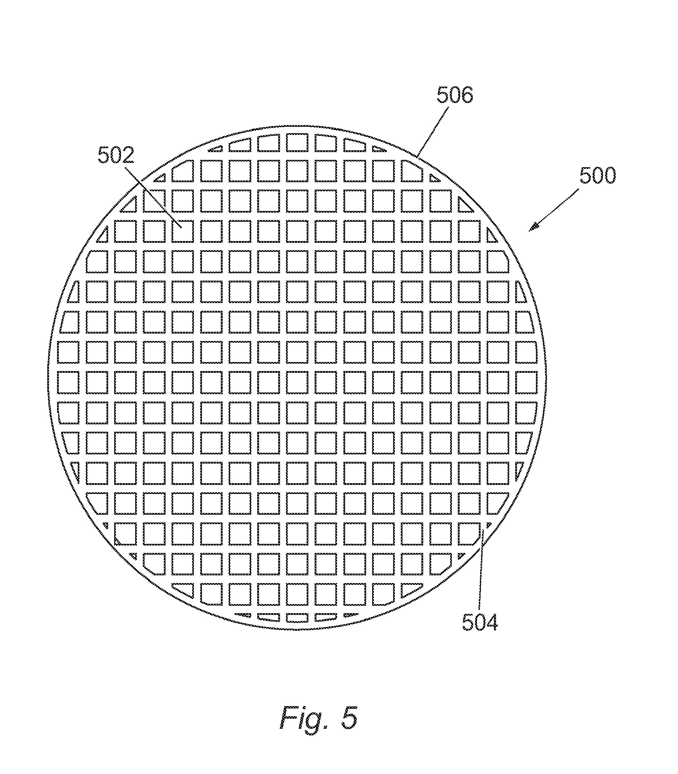

Figure 5 shows the top view of a glass/silicon laminate including a layer of filter coating in the form of the grid 500. The coated areas 502 coincide with the optical clear aperture is the low the filter layer and the uncoated areas coincide with the "sawing streets" 504 which enable the wafer to be cut into individual CPS modules. There is also an uncoated border 506.

It will be appreciated that the grid may take many different forms depending on the underlying arrangement of sensors or other devices which require this type of filter. The grid can be regular or irregular and the relative sizes of this filter and the gap between can be variable.

It should be noted that reference to light or radiation is intended to encompass all frequencies of radiation in which a digital image sensor may operate.

The application of a filter in accordance with the present invention may be applied to any combination of material, not just glass and silicon as described herein. The application of the filter can apply to any situation where warping due to thermal expansion differences occurs.

The digital image sensor in accordance with the present invention is suitable for use in any device which makes use of a digital image sensor. For example, the digital image sensor may be used in a camera, in camera modules or in a mobile telephone or any other computer related equipment.

It will be appreciated that this invention may be varied in many different ways and still remain within the intended scope of and spirit of the invention.

## Claims

1. A method of forming an image sensor of the type having a sensor, a cover and a filter, the method comprising the steps of:
- applying a filter layer to a cover layer by masking the cover layer with a predetermined pattern and applying the filter layer by a deposition process,
- bonding the cover layer to a sensor layer including a plurality of sensors wherein the predetermined pattern gives rise to a filter layer which is aligned with each sensor and wherein there are gaps in the filter layer around each sensor.

2. The method of claim 1, further comprising bonding the cover layer to the sensor layer after applying the filter layer.

3. The method of claim 1 or 2, further comprising cutting the layers into individual image sensors.

4. The method of claim 3, further comprising cutting the layers along the gaps in the filter layer.

5. The method of any preceding claim, wherein the step of applying the filter comprises applying a shadow mask on or near the cover layer.

6. The method of any preceding claim, wherein the step of applying the filter comprises applying the filter by vapour deposition.

7. An image sensor comprising a cover layer, a filter layer and a sensor layer made in accordance with the method of any preceding claim.

8. The image sensor of claim 7, wherein the cover layer is a glass layer.

9. The image sensor of claim 7 or claim 8, wherein, the sensor layer is a silicon layer.

10. The image sensor of any of claims 7 to 9, wherein the filter layer is a UV-IR filter layer.

11. A mobile telephone comprising the image sensor of any one of claims 7 to 10.

12. A camera comprising the digital image sensor of any one of claims 7 to 10.

13. A camera module comprising the digital image sensor of any one of claims 7 to 10.
